Europäisches Patentamt

(19) European Patent Office    (11) Publication number: **0 050 037**

Office européen des brevets    **B1**

(12) **EUROPEAN PATENT SPECIFICATION**

(45) Date of publication of patent specification: **30.12.86**    (51) Int. Cl.⁴: **G 11 C 11/40**

(21) Application number: **81304761.0**

(22) Date of filing: **13.10.81**

(54) Semiconductor memory device.

(30) Priority: **15.10.80 JP 144161/80**

(43) Date of publication of application:
**21.04.82 Bulletin 82/16**

(45) Publication of the grant of the patent:
**30.12.86 Bulletin 86/52**

(84) Designated Contracting States:
**DE FR GB NL**

(56) References cited:
**US-A-4 185 321**

**PATENTS ABSTRACTS OF JAPAN, vol. 3, no.
129 (E-147), 26th October 1979, page 48 E 147;
& JP - A - 54 106 137 (NIPPON DENSHIN
DENWA KOSHA) 20-08-1979**

(73) Proprietor: **FUJITSU LIMITED**
**1015, Kamikodanaka Nakahara-ku
Kawasaki-shi Kanagawa 211 (JP)**

(72) Inventor: **Oritani, Atsushi
37-22 Nakakibogaoka Asahi-ku
Yokohama-shi Kanagawa 241 (JP)**

(74) Representative: **Rackham, Stephen Neil et al
GILL JENNINGS & EVERY 53-64 Chancery Lane
London WC2A 1HN (GB)**

Courier Press, Leamington Spa, England.

## Description

The present invention relates to a semiconductor memory device and more particularly to a static type semiconductor RAM (Random Acess Memory) device.

In general, the current consumption of memory cells and bit lines of a static type RAM device increases with an increase in its memory capacity, i.e. with an increase in the number of the memory cells it contains. Therefore, especially in a RAM device having a large memory capacity, the gm of each of the load transistors connected to the bit lines is made as small as possible to decrease the current consumption of the bit lines.

However, this reduction in the gm of the load transistors slows down the speed of charging of the bit lines and hence reduces the access time of the memory device.

US—A—4185321 describes a semiconductor memory device comprising a plurality of word lines, a plurality of bit lines, a plurality of memory cells arranged at the crossing points between the word lines and the bit lines, load circuits each connected between one of the bit lines and a voltage source $V_{DD}$ to charge and discharge the bit line, the memory cell arranged at the crossing point of a particular word line and a particular bit line being selected by selecting that particular word line and that particular bit line, a further charging circuit in parallel with the load circuit for charging all of the bit lines, and NOR gating means for gating outputs of the address decoders to activate the further charging circuit for a limited length of time after a change of address has been detected. In the arrangement disclosed in this specification an address change is detected with the aid of a NOR gate linked to all of the address decoders and the NOR gate triggers a pulse generator which enables a further charging means connected in parallel with the normal charging means to quickly charge the word or bit lines. The NOR gating means in this arrangement includes a further NOR gate which is used to determine the time for which the further charging circuit is activated.

According to this invention in such a semiconductor memory device the word lines are connected to the NOR gating means to control the further charging circuit in accordance with the potential of the word lines. Thus, the present invention is a simplification requiring only single NOR gate and using the signals appearing on the word lines themselves to control the further charging circuit. This enables the access time of a static type random device to be decreased without increasing its overall current consumption.

A particular example of a semiconductor memory device in accordance with this invention will now be described and contrasted with the prior art with reference to the accompanying drawings; in which:—

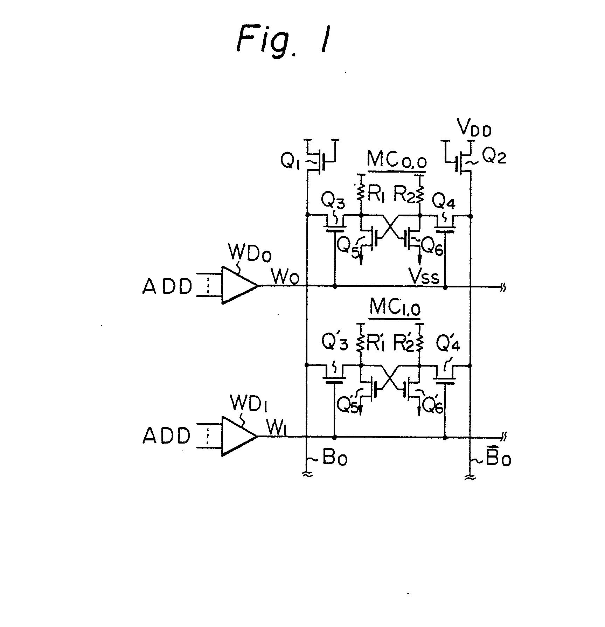

.Figure 1 is a circuit diagram of part of a conventional static type RAM device;

Figure 2 is a circuit diagram of part of a static type RAM device in accordance with the present invention; and,

Figures 3A to 3E are waveform diagrams illustrating the operation of the RAM device in accordance with this invention.

As illustrated in Figure 1, a conventional static type RAM device comprises a plurality of memory cells $MC_{0,0}$, $MC_{1,0}$; . . .; word lines $W_0$, $W_1$, . . .; pairs of bits lines $B_0$ and $\bar{B}_0$, . . .; word decoders $WD_0$, $WD_1$, . . .; and load MIS transistors $Q_1$, $Q_2$, . . . of each of the bit lines $B_0$ and $\bar{B}_0$. Each of the memory cells $MC_{0,0}$; $MC_{1,0}$; . . . has the same circuit structure and comprises load resistors $R_1$ and $R_2$ and MIS transistors $Q_3$ to $Q_6$. The drain electrodes and the gate electrodes of the transistors $Q_5$ and $Q_6$ are cross-coupled so as to form a flip-flop type memory cell circuit.

In the memory device of Figure 1, when, for example, the word line $W_0$ is selected by address signals ADD and the output potential of the word decoder $WD_0$, i.e. the word line $W_0$ becomes the potential level in a selected condition, for example high, the transistors $Q_3$ and $Q_4$ are both turned on. In this condition, if the transistors $Q_6$ of the memory cell $MC_{0,0}$ is in a turned on condition, a current flows from a voltage source $V_{DD}$ through the transistors $Q_2$, $Q_4$ and $Q_6$ to another voltage source $V_{SS}$, so that the potential of the bit line $\bar{B}_0$ becomes low. Since the transistor $Q_5$ of the same memory cell $MC_{0,0}$ is in a turned off condition, the potential level of the bit line $B_0$ is high. The potential difference between the bit lines $\bar{B}_0$ and $B_0$ is detected by a sense amplifier (not shown in the drawing) and information from the selected memory cell $MC_{0,0}$ is outputted.

In the above-mentioned RAM device, if the memory cell $MC_{1,0}$ is selected next to the memory cell $MC_{0,0}$ and if the memory cell $MC_{1,0}$ stores a different data from that of the memory cell $MC_{0,0}$, i.e., a transistor $Q'_5$ is in a turned on condition and a transistor $Q'_6$ is in a turned off condition, it is necessary to electrically charge the bit line $\bar{B}_0$ to a high potential level quickly. However, since, as aforementioned, the gm of the load transistors $Q_1$ and $Q_2$ is caused to be small in order to decrease the current consumption of the bit lines of a memory device having a large memory capacity, it is impossible to quickly charge the bit line $\bar{B}_0$ from low to high. Therefore, the access time of such a conventional memory device cannot be short. If the read-out of information from the memory cell $MC_{1,0}$ is effected just after the write-in of information to the memory cell $MC_{0,0}$ and if the memory cell $MC_{1,0}$ stores data different from that written in to the memory cell $MC_{0,0}$, it is necessary to electrically charge the bit line, for example, $\bar{B}_0$, from a very low potential (e.g. 0 V) to a high potential (e.g. 3 V), so that the access time of the RAM device becomes still longer than that in the above-mentioned case.

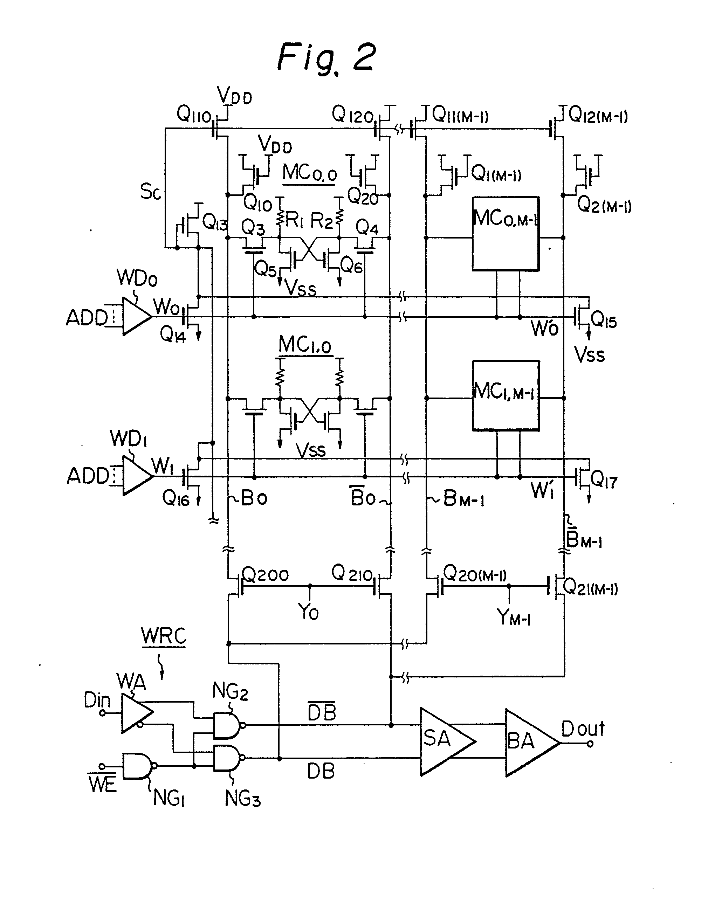

Fig. 2 illustrates a static type RAM device as an embodiment of the present invention. In Fig. 2, the same parts as appear in Fig. 1 are designated by the same reference symbols. The RAM device of Fig. 2 comprises a plurality of memory cells $MC_{0,0}, \ldots, MC_{0,M-1}, MC_{1,0}, \ldots, MC_{1,M-1}, \ldots$ disposed at cross points between a plurality of word lines $W_0, W_1, \ldots$ and a plurality of pairs of bit lines $B_0$ and $\overline{B}_0$ through $B_{M-1}$ and $\overline{B}_{M-1}$; a plurality of word decoders $WD_0, WD_1 \ldots$ connected to the word lines $W_0, W_1, \ldots$ respectively; and pairs of gate transistors $Q_{200}$ and $Q_{210}$ through $Q_{20(M-1)}$ and $Q_{21(M-1)}$ connected to the pairs of bit lines $B_0$ and $\overline{B}_0$ through $B_{M-1}$ and $\overline{B}_{M-1}$ respectively, and controlled by column decode signals $Y_0$ through $Y_{M-1}$ respectively. The RAM device of Fig. 2 further comprises load transistors $Q_{10}$ and $Q_{20}$ through $Q_{1(M-1)}$ and $Q_{2(M-1)}$ connected between the pairs of the bit lines $B_0$ and $\overline{B}_0$ through $B_{M-1}$ and $\overline{B}_{M-1}$ and a power source $V_{DD}$ respectively; a write-in circuit WRC constituted by an amplifier WA and three NAND gates NG1 through NG3 and whose output terminals are connected to a pair of data bit lines DB and $\overline{DB}$; a sense amplifier SA connected to the pair of data bit lines DB and $\overline{DB}$; and an output buffer amplifier BA connected to the sense amplifier SA.

The RAM device of Fig. 2 still further comprises, according to the present invention, a high speed charging circuit constituted by MIS charging transistors $Q_{110}$ and $Q_{120}$ through $Q_{11(M-1)}$ $Q_{12(M-1)}$ and by MIS transistors $Q_{13}, Q_{14}, Q_{15}, Q_{16}, Q_{17}, \ldots$. The MIS charging transistors $Q_{110}$ and $Q_{120}$ through $Q_{11(M-1)}$ and $Q_{12(M-1)}$ are connected parallel to the load transistors $Q_{10}$ and $Q_{20}$ through $Q_{1(M-1)}$ and $Q_{2(M-1)}$, respectively. The MIS transistors $Q_{13}, Q_{14}, Q_{15}, Q_{16}, Q_{17}, \ldots$ constitute a NOR gate to generate a control signal $S_C$ supplied to the gate electrode of the MIS charging transistors $Q_{110}$ and $Q_{120}$ through $Q_{11(M-1)}$ and $Q_{12(M-1)}$. The MIS transistor $Q_{13}$ is a load transistor of the NOR gate. The gate electrodes of the MIS transistors $Q_{14}$ and $Q_{15}$ are connected to the word line $W_0$ at both ends thereof and the gate electrodes of the MIS transistors $Q_{16}$ and $Q_{17}$ are connected to the word line $W_1$ at both ends thereof. The other MIS transistors connected to the other word lines at both ends thereof are not shown in the drawing.

The charging transistors $Q_{110}$ and $Q_{120}$ through $Q_{11(M-1)}$ and $Q_{12(M-1)}$ are controlled by the output signal, i.e., the control signal $S_C$. That is, when all the transistors $Q_{14}, Q_{15}, Q_{16}, Q_{17}, \ldots$ are in a turned off condition, the output signal $S_C$ of the NOR gate becomes high so that all the charging transistors $Q_{110}$ and $Q_{120}$ through $Q_{11(M-1)}$ and $Q_{12(M-1)}$ are turned on. On the contrary, when at least one of the transistors $Q_{14}, Q_{15}, Q_{16}, Q_{17}, \ldots$ is in a turned on condition, the output signal $S_C$ of the NOR gate becomes low so that all the charging transistors $Q_{110}$ and $Q_{120}$ through $Q_{11(M-1)}$ and $Q_{12(M-1)}$ are turned off. The transistors $Q_{14}$ and $Q_{15}$ (or $Q_{16}$ and $Q_{17}$ or other transistors not shown in the drawing) detect potential levels of one end portion of the word line $W_0$ (or $W_1, \ldots$) and of another end portion of the same word line $W'_0$ ($W'_1, \ldots$). Therefore, the charging transistors $Q_{110}$ and $Q_{120}$ through $Q_{11(M-1)}$ and $Q_{12(M-1)}$ are not turned on until the potential of all portions of the word lines $W_0, W_1, \ldots$ becomes low level, i.e., the level of non-selected condition even when the potential of each portion of the word line does not change at the same time due to the propagation delay of the word line along the longitudinal direction thereof. On the contrary, the charging transistors $Q_{110}$ and $Q_{120}$ through $Q_{11(M-1)}$ and $Q_{12(M-1)}$ are turned on immediately after the output potential of at least one of the word decoders $WD_0, WD_1, \ldots$ becomes high level, i.e., the potential level in the selected condition of the word line.

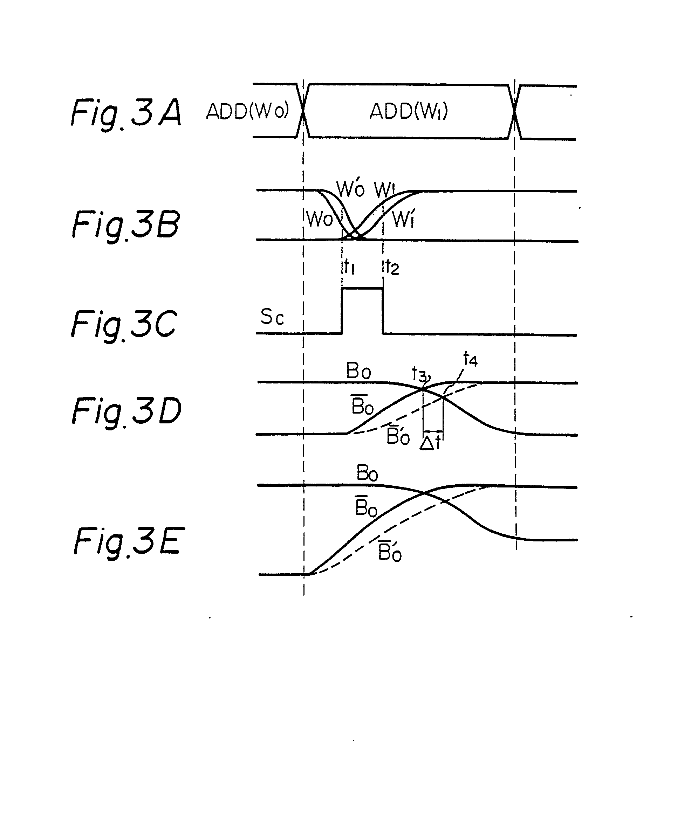

With reference to Fig. 3A through Fig. 3E, operation of the above-mentioned RAM device will now be explained. Assume that, as illustrated in Fig. 3A, the word address signal ADD has changed from $ADD(W_0)$ which selects the word line $W_0$ to $ADD(W_1)$ which selects the word line $W_1$ at a time $t_0$ and pairs of bit lines $B_0$ and $\overline{B}_0$ are continuously selected before and after the time $t_0$. That is, the memory cell $MC_{0,0}$ is selected before the time $t_0$ and the memory cell $MC_{1,0}$ is selected after the time $t_0$. Assume also that the read-out operations from both the memory cells $MC_{0,0}$ and $MC_{1,0}$ are sequentially effected and the memory cells $MC_{0,0}$ and $MC_{1,0}$ stores different information from each other. In this condition, if the transistor $Q_5$ of the memory cell $MC_{0,0}$ is in a turned off condition and the transistor $Q_6$ of the same memory cell is in a turned on condition, the potentials of the bit lines $B_0$ and $\overline{B}_0$ are high (e.g. 3 V) and low (e.g. 2 V) respectively (Fig. 3D), the potentials of the word lines $W_0$ and $W_1$ are high and low respectively and the potentials of the end portions $W'_0$ and $W'_1$ of the word lines $W_0$ and $W_1$ are also high and low, respectively (Fig. 3B), at the time $t_0$. After the word address signal ADD has changed from $ADD(W_0)$ to $ADD(W_1)$, the output signal of the word decoder $WD_0$, i.e., the potential of the word line $W_0$ changes from high to low and the output signal of the word decoder $WD_1$, i.e., the potential of the word line $W_0$, changes from low to high. In this case, the potentials of the end portions $W'_0$ and $W'_1$ of the word lines $W_0$ and $W_1$ change a short time after the potential of the beginning portions of the word lines $W_0$ and $W_1$ have changed. In Fig. 3B, the curves of the potentials of the beginning portion of the word lines $W_0$ and $W_1$ are designated by the symbols $W_0$ and $W_1$ respectively. As a result, all the input signals of the NOR gate constituted by the transistors $Q_{13}$ through $Q_{17}$ and others become low at a time $t_1$ when the potential of the end portion $W'_0$ of the word line $W_0$ becomes low, so that the output signal $S_C$ of the NOR gate becomes high as illustrated in Fig. 3C. At a time $t_2$, the output potential $W_1$ of the word decoder $WD_1$ firstly becomes high and the output signal $S_C$ of the NOR gate becomes low. Therefore, during the time period between $t_1$ and $t_2$, no word line is selected and the output signal $S_C$ becomes high. In the present invention, the charging transistors $Q_{110}$ and $Q_{120}$ through $Q_{11(M-1)}$ and $Q_{12(M-1)}$ are turned on during this non-selected time period and the bit lines $B_0$ and $\overline{B}_0$ are quickly charged

through the charging transistors $Q_{110}$ and $Q_{120}$ and through the load transistors $Q_{10}$ and $Q_{20}$. Therefore, the potential curve of the bit line $\bar{B}_0$ rises quickly and crosses the potential curve of the bit line $B_0$ at a time $t_3$ as illustrated in Fig. 3D. A curve $\bar{B}'_0$ of the dotted line of Fig. 3D illustrates a charging characteristics of the conventional memory device of Fig. 1 in which the bit lines $B_0$ and $\bar{B}_0$ are charged only by the load transistors $Q_1$ and $Q_2$, respectively. The dotted line curve $\bar{B}'_0$ crosses the curve $B_0$ at a time $t_4$ which is later than the time $t_3$ by $\Delta t$. Since the transfer gate transistors $Q_{200}$ and $Q_{210}$ of Fig. 2 connected between the bit lines $B_0$ and $\bar{B}_0$ and the data bit lines DB and $\overline{DB}$ are in a turned on condition, the abovementioned potential changes are transferred to the sense amplifier SA and the buffer amplifier BA. The sense amplifier detects the potential change of the bit lines $B_0$ and $\bar{B}_0$ and changes the potential of the read-out signal $D_{out}$ after the cross point of the potential curves $B_0$ and $\bar{B}_0$ (or $\bar{B}'_0$). Therefore, according to the present invention, the access time of the RAM device can be decreased by $\Delta t$. Since the charging transistors $Q_{110}$ and $Q_{120}$ through $Q_{11\ (M-1)}$ and $Q_{12\ (M-1)}$ are only turned on temporarily, the current consumption of the RAM device does not increase much.

In the above-mentioned memory device, the write-in of information to the memory cell, for example, $MC_{0,\ 0}$ is effected by applying a write-in data signal $D_{in}$ and an inverted write enable signal $\overline{WE}$ of low potential level to the write-in circuit WRC and by turning on the transfer gate transistors $Q_{200}$ and $Q_{210}$ by the column decode signal $Y_0$ and the transistors $Q_3$ and $Q_4$ by the output signal of the word decoder $WD_0$. Assume that the potentials of the data bit lines DB and $\overline{DB}$ are caused to be high (e.g. 3 V) and low (e.g. 0 V) respectively according to the write-in data signal $D_{in}$ supplied to the write-in circuit WRC. These high and low potentials are transferred to the memory cell $MC_{0,\ 0}$ through the transfer gate transistors $Q_{200}$ and $Q_{210}$ and through the transistors $Q_3$ and $Q_4$ and the write-in of information is effected.

If the read-out operation from the memory cell $MC_{1,\ 0}$ is effected after the above-mentioned write-in to the memory cell $MC_{0,\ 0}$ is effected and if the data stored in the memory cell $MC_{1,\ 0}$ is different from the data written into the memory cell $MC_{0,\ 0}$, the bit line $\bar{B}_0$ must be charged from the low potential (0 V) of the write-in mode to the high potential (3 V) of the read-out mode quickly. In the RAM device according to the present invention, the charging transistors $Q_{110}$ and $Q_{120}$ through $Q_{11\ (M-1)}$ and $Q_{12\ (M-1)}$ are also turned on temporarily in a similar manner to the aforementioned case, and, therefore, the potential of the bit line $\bar{B}_0$ rises quicker than that of the conventional RAM device as illustrated in Fig. 3E. Therefore, in even the worst case, the access time of the RAM device of the present invention can be much shorter than that of the conventional RAM device.

As mentioned above, since the RAM device according to the present invention comprises the high speed charging circuit which charges all the bit lines during a short time when all the word lines are in a non-selected condition, the access time of the RAM device having a large memory capacity can be short without increasing the power consumption much, even when the size, and therefore the gm, of each of the load transistors of the bit lines is small.

## Claims

1. A semiconductor memory device comprising a plurality of word lines ($WD_0$, $WD_1$, ...), a plurality of bit lines ($B_0$, $\bar{B}_0$, ... $B_{M-1}$, $\bar{B}_{M-1}$), a plurality of memory cells ($MC_{0,\ 0}$, $MC_{0,\ 1}$, ...), arranged at the crossing points between the word lines ($WD_0$, $WD_1$, ...) and the bit lines ($B_0$, $\bar{B}_0$, ... $B_{M-1}$, $\bar{B}_{M-1}$), load circuits ($Q_{10}$, $Q_{20}$, ... $Q_{1\ (M-1)}$, $Q_{2\ (M-1)}$) each connected between one of the bit lines $B_1$, $\bar{B}_0$, ... $B_{M-1}$, $\bar{B}_{M-1}$) and a voltage source ($V_{DD}$) to charge the bit line, the memory cell ($MC_{0,\ 0}$, $MC_{0,\ 1}$) arranged at the crossing point of a particular word line and a particular bit line being selected by selecting that particular word line and that particular bit line, a further charging circuit ($Q_{110}$, $Q_{120}$, ... $Q_{11\ (M-1)}$, $Q_{12\ (M-1)}$), and NOR gating means for gating outputs of the address decoders to activate the further charging circuit ($Q_{110}$, $Q_{120}$, ... $Q_{11\ (M-1)}$, $Q_{12\ (M-1)}$) for a limited length of time after a change of address has been detected, characterised in that the word lines ($WD_0$, $WD_1$, ...) are connected to the NOR gating means ($Q_{13}$—$Q_{17}$) to control the further charging circuit ($Q_{110}$, $Q_{120}$, ... $Q_{11\ (M-1)}$, $Q_{12\ (M-1)}$) in accordance with the potential of the word lines ($WD_1$, $WD_1$).

2. A memory device according to claim 1, wherein the NOR gating means is a NOR gate having a plurality of input transistors ($Q_{14}$—$Q_{17}$) and a load transistor ($Q_{13}$).

3. A memory device according to claim 1 or 2, wherein the NOR gating means ($Q_{13}$—$Q_{17}$) detects the potential levels at the beginning portion and at the end portion of each of the word lines ($WD_0$, $WD_1$, ...).

4. A memory device according to any one of the preceding claims, wherein the NOR gating means is a NOR gate comprising a plurality of input transistors ($Q_{14}$—$Q_{17}$) which is double the number of word lines ($WD_0$, $WD_1$) and the load transistor ($Q_{13}$), each of the input transistors ($Q_{14}$—$Q_{17}$) being connected between the beginning portion of the word lines ($WD_0$, $WD_1$ ...) and the load transistor ($Q_{13}$) and between the end portion of the word line ($WD_0$, $WD_1$ ...) and the load transistor ($Q_{13}$).

5. A memory device according to any one of the preceding claims, wherein each of the memory cells (MC) is a flip-flop type memory cell comprising a pair of cross coupled MIS transistors ($Q_5$, $Q_6$), a pair of transfer gate MIS transistors ($Q_3$, $Q_4$) and a pair of load resistors ($R_1$, $R_2$).

**Patentansprüche**

1. Halbleiterspeichervorrichtung mit einer Vielzahl von Wortleitungen (WD$_0$, WD$_1$, . . .) einer Vielzahl von Bitleitungen (B$_0$, $\overline{B}_0$, . . . B$_{M-1}$, $\overline{B}_{M-1}$), einer Vielzahl von Speicherzellen (MC$_{0,\,0}$, MC$_{0,\,1}$, . . .), die an den Kreuzungspunkten zwischen den Wortleitungen (WD$_0$, WD$_1$, . . .) und den Bitleitungen (B$_0$, $\overline{B}_0$, . . . B$_{M-1}$, $\overline{B}_{M-1}$) angeordnet sind, Ladeschaltungen (Q$_{10}$, Q$_{20}$, . . . Q$_{1\,(M-1)}$, Q$_{2\,(M-1)}$), die jeweils zwischen einer der Bitleitungen (B$_1$, B$_0$, . . . B$_{M-1}$, $\overline{B}_{M-1}$) und einer Spannungsquelle (V$_{DD}$) angeordnet sind, um die Bitleitungen zu laden, wobei die Speicherzelle (MC$_{0,\,0}$, MC$_{0,\,1}$) an dem Kreuzungspunkt einer besonderen Wortleitung und einer besonderen Bitleitung ausgewählt wird durch Auswählen der besonderen Wortleitung und der besonderen Bitleitung, einer weiteren Ladeschaltung (Q$_{110}$, Q$_{120}$, . . . Q$_{11\,(M-1)}$, Q$_{12\,(M-1)}$), und NOR-Schaltungseinrichtungen zum Steuern der Ausgänge der Adressendecoder, um die weitere Ladeschaltung (Q$_{110}$, Q$_{120}$, . . . Q$_{11\,(M-1)}$, Q$_{12\,(M-1)}$) für eine begrenzte Zeitdauer, nachdem die Änderung der Adresse festgestellt worden ist, zu aktivieren, dadurch gekennzeichnet, daß die Wortleitungen (WD$_0$, WD$_1$, . . .) mit den NOR-Schaltungseinrichtungen (Q$_{13}$—Q$_{17}$) verbunden sind, um die weitere Ladeschaltung (Q$_{110}$, Q$_{120}$, . . . Q$_{11\,(M-1)}$, Q$_{12\,(M-1)}$) in Übereinstimmung mit dem Potential der Wortleitungen (WD$_1$, WD$_1$) zu steuern.

2. Speichervorrichtung nach Anspruch 1, bei welcher die NOR-Schaltungseinrichtung ein NOR-Verknüpfungsglied ist, welches eine Vielzahl von Eingangstransistoren (Q$_{14}$—Q$_{17}$) und einen Lasttransistor (Q$_{13}$) hat.

3. Speichervorrichtung nach Anspruch 1 oder 2, bei welcher die NOR-Schaltungseinrichtung (Q$_{13}$—Q$_{17}$) die Potentialpegel am beginnenden Abschnitt und am Endabschnitt jeder der Wortleitungen (WD$_0$, WD$_1$, . . .) detektieren.

4. Speichervorrichtung nach einem der vorhergehenden Ansprüche, bei welcher die NOR-Schaltungseinrichtung ein NOR-Glied ist, welches eine Vielzahl von Eingangstransistoren (Q$_{14}$—Q$_{17}$) umfaßt, die zweimal so groß wie die Zahl der Wortleitungen (WD$_0$, WD$_1$) und des Lasttransistors (Q$_{13}$) ist, und jede der Eingangstransistoren (Q$_{14}$—Q$_{17}$) zwischen dem beginnenden Abschnitt der Wortleitung (WD$_0$, WD$_1$ . . .) und dem Lasttransistor (Q$_{13}$) und zwischen dem Endabschnitt der Wortleitung (WD$_0$, WD$_1$ . . .) und dem Lasttransistor (Q$_{13}$) angeschlossen ist.

5. Speichervorrichtung nach einem der vorhergehenden Ansprüche, bei welcher jede der Speicherzellen (MC) eine Speicherzelle vom Flipflop-Typ ist, die ein Paar von über Kreuz gekoppelten MIS-Transistoren (Q$_5$, Q$_6$), ein Paar von Transfergate-MIS-Transistoren (Q$_3$, Q$_4$) und ein Paar von Lastwiderständen (R$_1$, R$_2$) umfaßt.

**Revendications**

1. Dispositif de mémoire semiconducteur comprenant plusieurs lignes de mot (WD$_0$, WD$_1$, . . .), plusieurs lignes de bit (B$_0$, $\overline{B}_0$, . . ., B$_{M-1}$, $\overline{B}_{M-1}$), plusieurs cellules de mémoire (MC$_{0,\,0}$, MC$_{0,\,1}$, . . .) disposées aux points de croisement entre les lignes de mot (WD$_0$, WD$_1$, . . .) et les lignes de bit (B$_0$, $\overline{B}_0$, . . ., B$_{M-1}$, $\overline{B}_{M-1}$), des circuits de charge (Q$_{10}$, Q$_{20}$, . . ., Q$_{1\,(M-1)}$, Q$_{2\,(M-1)}$) connectés chacun entre une des lignes de bit (B$_1$, $\overline{B}_0$, . . ., B$_{M-1}$, $\overline{B}_{M-1}$) et une source de tension (V$_{DD}$) afin de charger la ligne de bit, la cellule de mémoire (MC$_{0,\,0}$, MC$_{0,\,1}$) qui est disposée au point de croisement d'une ligne de mot particulière et d'une ligne de bit particulière étant sélectionnée par la sélection de cette ligne de mot particulière et de cette ligne de bit particulière, un circuit de charge supplémentaire (Q$_{110}$, Q$_{120}$, . . ., Q$_{11\,(M-1)}$, Q$_{12\,(M-1)}$), et un moyen à porte NI servant à laisser passer sous conditions des signaux de sortie des décodeurs d'adresse afin de rendre actif le circuit de charge supplémentaire (Q$_{110}$, Q$_{120}$, . . ., Q$_{11\,(M-1)}$, Q$_{12\,(M-1)}$) pendant une durée limitée après qu'un changement d'adresse à été détecté, caractérisé en ce que les lignes de mot (WD$_0$, WD$_1$, . . .) sont connectées au moyen à porte NI (Q$_{13}$ à Q$_{17}$) de manière à commander le circuit de charge supplémentaire (Q$_{110}$, Q$_{120}$, . . ., Q$_{11\,(M-1)}$, Q$_{12\,(M-1)}$) en fonction du potential des lignes de mot (WD$_1$, WD$_1$).

2. Dispositif de mémoire selon la revendication 1, où le moyen à porte NI est une porte NI possédant plusieurs transistors d'entrée (Q$_{14}$ à Q$_{17}$) et un transistor de charge (Q$_{13}$).

3. Dispositif de mémoire selon la revendication 1 ou 2, où le moyen à porte NI (Q$_{13}$ à Q$_{17}$) détecte les niveaux de potentiel sur la partie initiale et la partie terminale de chacune des lignes de mot (WD$_0$, WD$_1$, . . .).

4. Dispositif de mémoire selon l'une quelconque des revendications précédentes, où le moyen à porte NI est une porte NI comprenant plusieurs transistors d'entrée (Q$_{14}$ à Q$_{17}$) en nombre double du nombre des lignes de mot (WD$_0$, WD$_1$) et le transistor de charge (Q$_{13}$), chacun des transistors d'entrée (Q$_{14}$ à Q$_{17}$) étant connecté entre la partie initiale des lignes de mot (WD$_0$, WD$_1$, . . .) et le transistor de charge (Q$_{13}$) et entre la partie terminale de la ligne de mot (WD$_0$, WD$_1$, . . .) et le transistor de charge (Q$_{13}$).

5. Dispositif de mémoire selon l'une quelconque des revendications précédentes, où chacune des cellules de mémoire (MC) est une cellule de mémoire du type bascule comprenant une paire de transistors MIS couplés en croix (Q$_5$, Q$_6$), une paire de transistors MIS portes de transfert (Q$_3$, Q$_4$) et une paire de résistances de charge (R$_1$, R$_2$).

# Fig. 1

# Fig. 2

*Fig.3A*

ADD(Wo) ADD(Wi)

*Fig.3B*

W'o W'i

Wo Wi

$t_1$ $t_2$

*Fig.3C*

Sc

*Fig.3D*

$B_0$ $t_3$ $t_4$

$\overline{B}_0$

$\overline{B}'_0$ $\Delta t$

*Fig.3E*

$B_0$

$\overline{B}_0$

$\overline{B}'_0$